# EUROPEAN PATENT APPLICATION

(11) **EP 3 712 297 A1**
(43) Date of publication of application: **23.09.2020**
(21) Application number: 18755386.2
(22) Date of filing: 26.06.2018
(51) Int. Cl.: C23C 14/35

(54) **MAGNETRON SPUTTERING EQUIPMENT AND CATHODE DEVICE THEREOF**

(30) Priority: 29.03.2018 CN 201820443363 U
(71) Applicant: Beijing Apollo Ding Rong Solar Technology Co., Ltd, Beijing 100176 (CN)
(72) Inventor: The designation of the inventor has not yet been filed
(74) Representative: Cabinet Beau de Loménie
(86) International application number: PCT/CN2018/092751
(87) International publication number: WO 2019/184109

(57) **Abstract**

The present disclosure provides a magnetron sputtering apparatus and a cathode device of the magnetron sputtering apparatus. The cathode device includes a target material component, a magnetic circuit component, a transmission component and a driving component. The magnetic circuit component is configured to be opposite to the target material component. The magnetic circuit component includes a plurality of magnetic circuit units capable of independently generating magnetic field. The transmission component is connected with each of the magnetic circuit units simultaneously. The driving component is configured to drive the magnetic circuit component to reciprocate between a first position and a second position in a preset direction by the transmission component. The cathode device provides a plurality of magnetic fields to the target material component, so that spurring efficiency is improved. The driving component may be connected with respective magnetic circuit unit of the magnetic circuit component by the transmission component, so that the magnetic circuit component may be driven to integrally reciprocate so as to enlarge effective range of the magnetic field on the target material component, and then to decrease the non-etched region on the target material component and increase the etching region, so that use ratio of the target material component is increased to improve sputtering efficiency.

## Description

### CROSS REFERENCE TO RELATED APPLICATIONS

The present application is a Chinese Patent Application No. 201820443363.6, filed on March 29, 2018, and the entire contents thereof are incorporated herein by reference.

### TECHNICAL FIELD

The present disclosure relates to the technical field of magnetron sputtering, in particular, to a magnetron sputtering apparatus and a cathode device of the magnetron sputtering apparatus.

### BACKGROUND

The magnetron sputtering technique is a kind of film technique, which is widely used in the field of solar photovoltaic, integrated circuit, panel display and the like. The principle thereof is that, ions ionized by glow discharge bombards the target material, and then bombarded sputtered particles of the target material are deposited on the substrate to form a film layer.

In the cathode device of the current magnetron sputtering apparatus, a magnetic circuit component for generating magnetic field is usually disposed on a back side of the target material. However, the magnetic field provided by the magnetic circuit component is single and has a fixed position relative to the target material, so that a range of the magnetic field is constant. Thus, during sputtering, an etching position of the surface of the target material is correspondingly constant and the width of the target material is limited, while there is a large area of non-etched region on the target material, so that use ratio of the target material is lower, thereby making it difficult to improve sputtering efficiency and production capacity. Therefore, it is not suitable for industrial production. At the same time, sputtering of the edge region of the target material is uneven due to the limitation of the above magnetic field, and thus the sputtering coating is likely to be uneven.

It should be noted that the information disclosed in the above mentioned background is merely used to enhance understanding of the background of the present disclosure, and therefore may include information that does not constitute related art known to those skilled in the art.

### SUMMARY

The present disclosure is to provide a magnetron sputtering apparatus and a cathode device of the magnetron sputtering apparatus so as to improve the use ratio of target material and increase the sputtering efficiency.

According to one aspect of the present disclosure, a cathode device of a magnetron sputtering apparatus is provided, which includes a target material component; a magnetic circuit component, configured to be arranged opposite to the target material component, the magnetic circuit component comprising a plurality of magnetic circuit units capable of independently generating magnetic field; a transmission component, connected with each of the magnetic circuit units simultaneously; a driving component, configured to drive the magnetic circuit component to reciprocate between a first position and a second position in a preset direction by the transmission component.

In an exemplary embodiment of the present disclosure, the transmission component includes a drive screw and a plurality of driving sliders. The drive screw is disposed in the preset direction. The plurality of driving sliders is connected with the magnetic circuit units in one-to-one correspondence, and each of the driving sliders is sleeved on the drive screw and is threaded connected with the drive screw.

In an exemplary embodiment of the present disclosure, the cathode device further includes at least one guide components comprising a guide rail and a plurality of guide sliders. The guide rail is disposed in the preset direction. The plurality of guide sliders are connected with the magnetic circuit units in one-to-one correspondence, and each of the guide sliders is slidably connected with the guide rail.

In an exemplary embodiment of the present disclosure, the cathode device further includes a first limit component and a second limit component. The first limit component may be triggered when the magnetic circuit component moved to the first position, and may control the magnetic circuit component to move towards the second position by the driving component. The second limit component may be triggered when the magnetic circuit component moved to the second position, and may control the magnetic circuit component to move towards the first position by the driving component.

In an exemplary embodiment of the present disclosure, both the first limit component and the second limit component are proximity switches.

In an exemplary embodiment of the present disclosure, the magnetic circuit unit includes an insulating mat, a yoke and a magnet. The insulating mat is connected with the transmission component. The yoke is disposed at a surface of the insulating mat adjacent to the target material component. The magnet is disposed at a surface of the yoke adjacent to the target material component.

In an exemplary embodiment of the present disclosure, the cathode device further includes a cathode conductive component. One side of the cathode conductive component is configured to install the target material component, and another side thereof is arranged opposite to the magnetic circuit component. The cathode conductive component has a cooling water passage, wherein the cooling water passage has a water inlet, a water outlet, and wherein the cooling water passage includes at least two independent branches, each of the two independent branches being connected between the water inlet and the water outlet.

In an exemplary embodiment of the present disclosure, the cooling water passage extends in a curved or polylined shape.

In an exemplary embodiment of the present disclosure, the cathode conductive component includes a cathode conductive plate and a cooling partition. The cathode conductive plate is disposed between the target material component and the magnetic circuit component, and the cathode conductive plate is provided with a cooling groove. The cooling partition is configured to seal a surface of the cathode conductive plate adjacent to the target material component and covers the cooling groove sealingly to form the cooling water passage.

In an exemplary embodiment of the present disclosure, the cathode device further includes a protective cover. The protective cover has a receiving cavity. The receiving cavity has an open end. The cathode conductive component covers the open end and is fixed to the open end. The target material component is fixed to a surface of the cathode conductive component away from the protective cover. The magnetic circuit component, the transmission component and the driving component are all disposed within the receiving cavity.

According to another aspect of the present disclosure, a magnetron sputtering apparatus is provided, which includes the cathode device according to any of the above mentioned embodiments.

Advantageous effects of the present disclosure over the related art are as below.

Since the magnetic circuit component contains a plurality of magnetic circuit units, and each magnetic circuit unit may generate magnetic field independently so as to form a matrix magnetic field, and to simultaneously provide a plurality of magnetic fields to the target material component, so that spurring efficiency is improved with respect to the single magnetic field in the related art. At the same time, the driving component may be connected with respective magnetic circuit unit of the magnetic circuit component by the transmission component, so that the magnetic circuit component may be driven to integrally reciprocate so as to enlarge effective range of the magnetic field on the target material component, and then to decrease the non-etched region on the target material component and increase the etching region, so that use ratio of the target material component is increased to improve sputtering efficiency, production efficiency and production capacity, and thus it is suitable for industrial production. In addition, sputtering of the edge region of the target material component becomes uneven to ensure a more uniform sputtering coating. Moreover, for the target material component with a larger width, the plurality of magnetic circuit units are only required to move by a short displacement to enable their effective range to cover the target material component, so that position offset caused by excessive movement displacement may be avoided, thereby achieving accuracy control and enabling stability of the magnet field of the target surface in the preset direction.

It should be understood that the above general description and the following detailed description are intended to be illustrative and not restrictive of the present disclosure.

### BRIEF DESCRIPTION OF THE DRAWINGS

The accompanying drawings, which are incorporated in the specification and constitute part of the present specification, show embodiments in accordance with the present disclosure, and explain principle of the present disclosure together with this specification. It is obvious for those skilled in the art that the accompanying drawings in the following description are merely some embodiments of the present disclosure, and other drawings may also be obtained by these drawings without any creative work.
FIG. 1 schematically shows a schematic view of a cathode device in an embodiment of the present disclosure.
FIG. 2 schematically shows a schematic view of a magnetic circuit component in an embodiment of the present disclosure.
FIG. 3 schematically shows a schematic view of the magnetic circuit component of the cathode device located at a first position in an embodiment of the present disclosure.
FIG. 4 schematically shows a schematic view of the magnetic circuit component of the cathode device located at a second position in an embodiment of the present disclosure.
FIG. 5 schematically shows a schematic view of a cathode conductive plate of the cathode conductive component of the cathode device in an embodiment of the present disclosure.

In the drawings:
1. target material component; 101. target material; 102. back plate; 2. magnetic circuit component; 21. magnetic circuit unit; 211. insulating mat; 212. yoke; 213. magnet; 3. transmission component; 31. drive screw; 32. driving slider; 4. driving component; 5. guide component; 51. guide rail; 52. guide slider; 6. first limit component; 7. second limit component; 8. cathode conductive component; 801. water inlet; 802. water outlet; 81. cathode conductive plate; 811. first cooling groove; 812. second cooling groove; 82. cooling partition; 9. protective cover; 91. receiving cavity; 92. support; 10. insulating block; 11. partition pressure block; 12. target material pressure block; 13. vacuum pressure block; 14. cooling seal washer; 15. sealing ring; 16. vacuum seal washer; 17. anode cover.

### DETAILED DESCRIPTION

Exemplary embodiments will now be described more fully with reference to the accompanying drawings. However, exemplary embodiments can be embodied in a variety of forms, and should not be construed as being limited to the embodiments set forth herein. Rather, these exemplary embodiments are provided to enable the present disclosure thorough and complete. Conceptions of exemplary embodiments will be fully given to those skilled in the art. The drawings are only schematic representations of the disclosure, and are not necessarily to scale. The same reference numerals in the drawings denote the same or similar structures, and thus their detailed description will be omitted.

Relative terms such as "on" and "under" are used in the specification to describe relative relationship of one component with respect to another component in the drawings, however, these terms are used in this specification for convenience only, for example, the direction shown in the drawings. It should be understood that, a component located "on" as described will become a component located "under" if the device is turned upside down. When a structure is located "on" other structures, it is possible that a structure is integrally formed on other structures or that a structure is "directly" disposed on other structures, or that a structure is "indirectly" disposed on other structures by another structure.

The terms "a", "an", "the", "said" and "at least one" are used to denote that there are one or more elements/components and the like; the terms "include" and "have" are used to denote the meaning of "openly include" and it means that there also are other elements/components and the like in addition to the listed elements/components and the like; the terms "first", "second" and the like are only used as marks without limiting the number of objects.

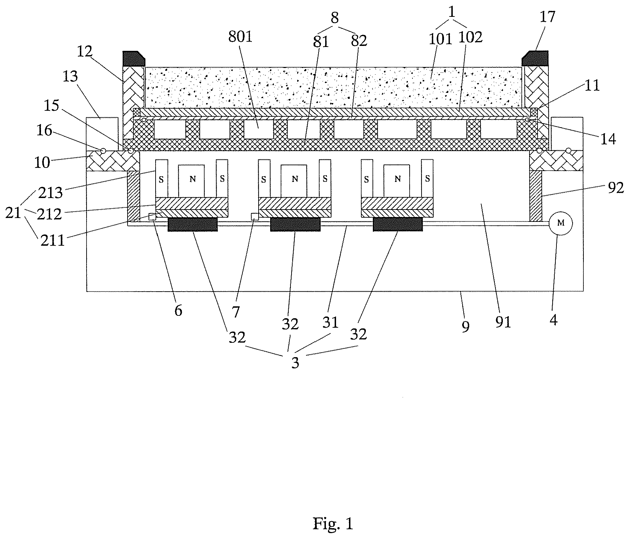

An embodiment of the present disclosure provides a cathode device of a magnetron sputtering apparatus. As shown in FIG. 1, the cathode device may include a target material component 1, a magnetic circuit component 2, a transmission component 3 and a driving component 4, wherein:

The magnetic circuit component 2 is arranged opposite to the target material component 1, and the magnetic circuit component 2 may include a plurality of independent magnetic circuit units 21, each of which may independently generate magnetic field. The transmission component 3 may simultaneously be connected with each of magnetic circuit units 21. The driving component 4 may be connected with the transmission component 3, and may drive the magnetic circuit component 2 to reciprocate between a first position and a second position in a preset direction by transmission component 3.

The cathode device of the embodiment of the present disclosure may form a matrix magnetic field by the plurality of magnetic circuit units 21 of the magnetic circuit component 2, thereby simultaneously providing a plurality of magnetic field to the target material component 1. Compared to the single magnetic field in the related art, sputtering efficiency is improved. In addition, the driving component 4 is connected with each of magnetic circuit units 21 of the magnetic circuit component 2 by the transmission component 3, so that the magnetic circuit component 2 is driven to integrally reciprocate so as to enlarge effective range of the magnetic field on the target material component 1, and then to increase width of the target material, thereby decreasing the non-etched region on the target material component, increasing the etching region. Then, use ratio of the target material component 1 is increased to improve sputtering efficiency, production efficiency and then production capacity, and it is suitable for industrial production. In addition, sputtering of the edge region of the target material component becomes even to ensure a more uniform sputtering coating. Moreover, for the target material component with a larger width, the plurality of magnetic circuit units 21 are only required to move by a short displacement to enable their effective range to cover the target material component, so that position offset caused by excessive movement displacement may be avoided, thereby achieving accuracy control and enabling stability of the magnet field of the target surface in the preset direction.

Various components of the cathode device of embodiments of the present disclosure will be described in detail below.

As shown in FIG. 1, in one embodiment, the target material component 1 may include a target material 101 and a back plate 102, wherein shape of the target material 101 may be rectangular or other shapes, and wherein material thereof will not be particularly defined. The shape of the back plate 102 may be same as that of the target material 101, but the size of the back plate 102 may be larger than that of the target material 101. The target material 101 may be bound on the back plate 102 with Metal indium, and detail of the binding process will not be described.

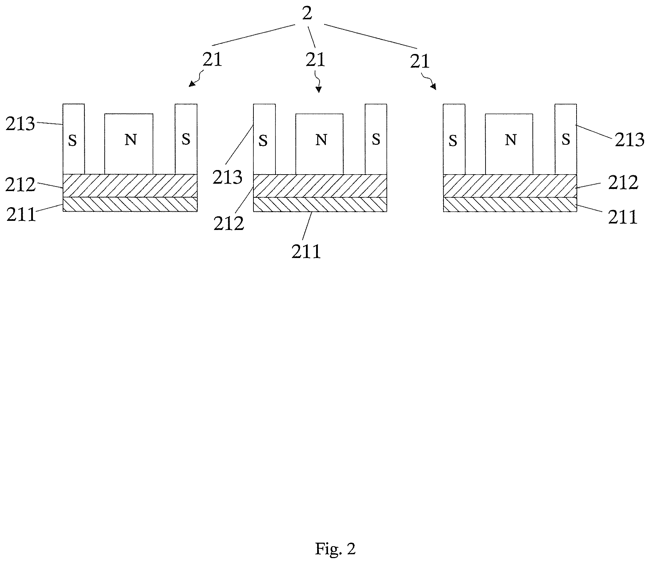

As shown in FIG. 1 and FIG. 2, in one embodiment, the magnetic circuit component 2 may be arranged opposite to the target material component 1. Specifically, the magnetic circuit component 2 may be arranged opposite to the back plate 102 of the target material component 1, so that the target material 101 is located at a side of the back plate 102 away from the magnetic circuit component 2. The magnetic circuit component 2 may include a plurality of magnetic circuit units 21, each of which may independently generate magnetic field, the number of the magnetic circuit units 21 may be two or three, but not limited thereto, and may also be plural which may be specifically decided according to the size of the target material component 1, i.e. as the size of the target material component 1 becomes larger, the number of the magnetic circuit units 21 may be more. In addition, the plurality of magnetic circuit units 21 may be disposed on the same plane, and may be spaced apart in a preset direction, i.e. there is an interval between two adjacent magnetic circuit units 21. For example, the shape of the target material component 1 is rectangle, the preset direction may be a longitudinal direction or a width direction of the target material component 1.

Each magnetic circuit unit 21 may use the same structure. Taking a magnetic circuit unit 21 as an example, as shown in FIG. 2, the magnetic circuit unit 21 may include a insulating mat 211, a yoke 212 and a magnet 213, wherein,

The insulating mat 211 may be a flat plate structure, the insulating mat 211 of each magnetic circuit unit 21 may be spaced apart side by side. Material of the insulating mat 211 may be Polytetrafluoroethylene (PTFE) so as to present good weatherability. Of course, material of the insulating mat 211 may also be other material with better weatherability, which will not be enumerated herein. In addition, the insulating mat 211 may be fixedly connected with the transmission component 3, thereby connecting the magnetic circuit unit 21 and the transmission component 3.

The yoke 212 may be disposed on a surface of the insulating mat211 adjacent to the target material component 1, and may be fixedly connected with the insulating mat 211. The shape and size of the yoke 212 may be same as that of the insulating mat 211, and may be made of mild steel DT4 so as to have high magnetic permeability and low remanence characteristics. Of course, the yoke 212 may also use other material with better magnetic permeability. At the same time, the surface of the yoke 212 adjacent to the target material component 1 may be provided with a slot for mounting the magnet 213.

The magnet 213 may be disposed at the surface of the yoke 212 adjacent to the target material component 1, and may be snap fit within the slot of the yoke 212, so as to enable the magnet 213 to be fixed. Of course, the magnet 213 may be fixed in other ways. The magnet 213 may include a plurality of magnets arranged in a magnetic pole arrangement of S-N-S, each of which may be processed and magnetized by an iron-cobalt-nickel material, and of course, the magnet may also be other ferromagnetic materials. One or more magnets 213 may be disposed on the same yoke 212. In other embodiments of the present disclosure, the arrangement of the magnetic poles may also be in the form of N-S-N or other forms, which will not be enumerated herein.

It should be understood that the structure of the magnetic circuit unit 21 is merely exemplary. In other embodiments of the present disclosure, the magnetic circuit unit 21 may be other structures as long as they can perform the same function, contents of which will not be described in detail.

As shown in FIG. 1, in one embodiment, the transmission component 3 may simultaneously be connected to each of the magnetic circuit units 21 of the magnetic circuit component 2, so as to drive the magnetic circuit component 2 to integrally reciprocate in a preset direction. For example, the transmission component 3 may include a drive screw 31 and a driving slider 32, wherein:

The drive screw 31 may be disposed in the preset direction. For example, the drive screw 31 may be disposed at a side of the magnetic circuit component 2 away from the target material component 1, and projection of the drive screw 31 on the magnetic circuit component 2 coincides with a central axis of the magnetic circuit component 2, and projections of both ends of the drive screw 31 may extend beyond edges of the magnetic circuit component 2. Of course, the drive screw 31 may be disposed at a position offset from the central axis of the magnetic circuit component 2.

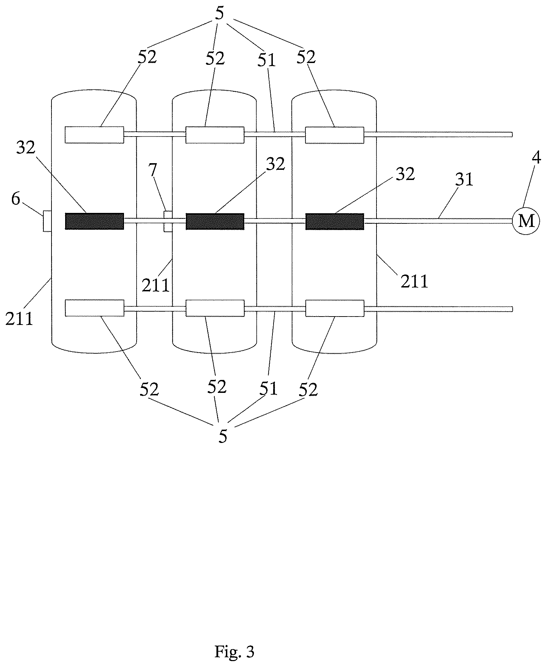

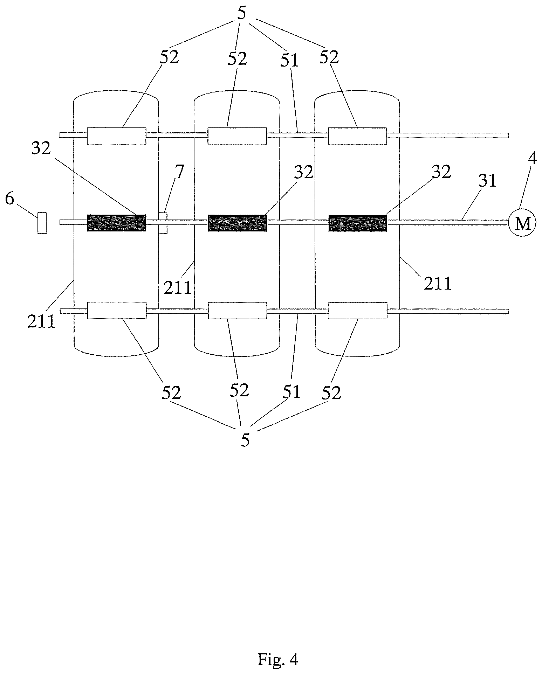

The number of the driving slider 32 may be the same as that of the magnetic circuit units 21, that is, the driving slider 32 may also be plural. The plurality of driving sliders 32 may be sequentially sleeved on the drive screw 31 along the axial direction of the drive screw 31, and each of the driving sliders 32 is threaded connected with the drive screw 31, so that each driving slider 32 may constitute a feed screw nut pair with the drive screw 31. Thus, by rotating the drive screw 31, each of driving sliders 32 is simultaneously linearly moved along the drive screw 31 so as to drive each magnetic circuit unit 21 to move synchronously in a preset direction, so that the magnetic circuit component 2 moves integrally and synchronously in a preset direction. By changing the direction of rotation of the drive screw 31, the driving slider 32 may be reciprocated to reciprocate the magnetic circuit component 2. For example, as shown in FIG. 3 and FIG. 4, each of the driving sliders 32 may be connected to the side of the insulating mat 211 of each magnetic circuit unit 21 away from the yoke 212, thereby moving the magnetic circuit units 21. The connection method may be snap fit connection or threaded connection, and will not be particularly limited herein. It should be understood that, in order to simplify the structure, the driving slider 32 and the corresponding insulating mat 211 of the magnetic circuit unit 21 may be integrally formed.

In other embodiments of the present disclosure, the transmission component 3 may also be other structures as long as the magnetic circuit component 2 can be driven to reciprocate in a preset direction. For example, the transmission component 3 may also be a straight rod disposed in the preset direction, and the straight rod may be connected with each of magnetic circuit units 21. The movement of the magnetic circuit component 2 may also be achieved by driving the straight rod to reciprocate.

As shown in FIG. 1, in one embodiment, the driving component 4 may be connected with the transmission component 3, and may drive each of magnetic circuit units 21 to the driving component 4 may be connected with the transmission component 3 so as to reciprocate the magnetic circuit component 2 in a preset direction. For example, for the transmission component 3 using the above-mentioned drive screw 31 and the driving slider 32, the driving component 4 is a servo motor, and the servo motor may be connected with one end of the drive screw 31 through a universal joint, of course, it may be directly connected with the drive screw 31 thereby driving the drive screw 31 to be rotated. The reciprocating movement of the magnetic circuit component 2 may be realized by controlling forward and reverse rotation of the servo motor. The specific transmission principle may refer to example descriptions of the transmission component 3, and will not be described in detail herein.

In other embodiments of the present disclosure, the transmission component 3 is a straight rod disposed in a preset direction, the straight rod may connected with each of magnetic circuit units 21. The driving component 4 may be a cylinder, and the cylinder may be connected with the straight rod, so as to drive the reciprocating movement of the straight rod, and then the reciprocating movement of the magnetic circuit component 2 may also be achieved. Of course, the cylinder may also be replaced by a linear motor or the like that can output linear motion.

As shown in FIG. 3 and FIG. 4, in an embodiment, the cathode device of the embodiment of the present disclosure further includes a guide component 5, and the guide component 5 may be connected with the magnetic circuit component 2 for guiding the magnetic circuit component 2 to move in a preset direction. For example, the guide component 5 may include a guide rail 51 and a guide slider 52, wherein:

The guide rail 51 may be disposed at a side of the magnetic circuit component 2 away from the target material component 1 in the above-mentioned preset direction, and may be parallel to the drive screw 31.

The number of the guide sliders 52 may be the same as that of the magnetic circuit units 21, that is, the number of the guide sliders 52 is plural. Each of the guide sliders 52 may be distributed along an extending direction of the guide rail 51, and may be slidably engaged with the guide rail 51. At the same time, each of the guide sliders 52 may be connected with the insulating mat 211 of the magnetic circuit units 21 in a one-to-one correspondence by threaded connection or the like. Of course, the guide sliders 52 may be integrally formed with the corresponding insulating mat 211. Thus, the magnetic circuit unit 21 may be guided to reciprocally slide in a preset direction by cooperation of the guide slider 52 and the guide rail 51, thereby preventing deflection while supporting the magnetic circuit unit 21.

The number of the guide components 5 may be two. The guide rail 51 of two guide components 5 may be arranged in parallel and symmetrically distributed on both sides of the feed screw 31. The guide slides 52 on the two guide rails 51 are connected with magnetic circuit units 21 in one-to-one correspondence, that is, each magnetic circuit unit 21 is connected to two guide sliders 52. Of course, in other embodiments of the present disclosure, the number of the guide components 5 may also be one, three or more, and will not be described in detail herein.

As shown in FIG. 3 and FIG. 4, in an embodiment, the cathode device of the embodiment of the present disclosure further includes a first limit component 6 and a second limit component 7, the first limit component 6 and the second limit component 7 may be in the same plane as the magnetic circuit component 2, and the first limit component 6 and the second limit component 7 may be separately disposed on two sides of the at least one magnetic circuit unit 21, that is, at least one magnetic circuit unit 21 is provided between the first limit component 6 and the second limit component 7 and may be triggered by the magnetic circuit component 2 as the magnetic circuit component 2 moves. At the same time, both the first limit component 6 and the second limit component 7 may use a proximity switch. Of course, other limiting switches and the like may be configured to limit components of the magnetic circuit component 2 moving between the first position and the second position, which will not be enumerated herein.

For example, as shown in FIG. 3, both the first limit component 6 and the second limit component 7 are proximity switches, and the driving component 4 is a motor. When the magnetic circuit component 2 is moved to the position, the first limit component 6 is triggered by the magnetic circuit component 1. At this time, the first limit component 6 may control the driving component 4 to change the steering, so that the magnetic circuit component 2 is moved to the second position. As shown in FIG. 4, when the magnetic circuit component 2 is moved to the second position, the second limit component 7 is triggered. At this time, the second limit component 7 may control the driving component 4 to change the direction of rotation again so that the magnetic circuit component 2 is moved to the first position. The arrangement of the first limit component 6 and the second limit component 7 may automatically and accurately reciprocate the magnetic circuit component 2 between the first position and the second position, thereby avoiding manual control, improving work efficiency, and simultaneously ensuring sputtering area of the target material of each product to be consistent, and improving sputtering quality of the product.

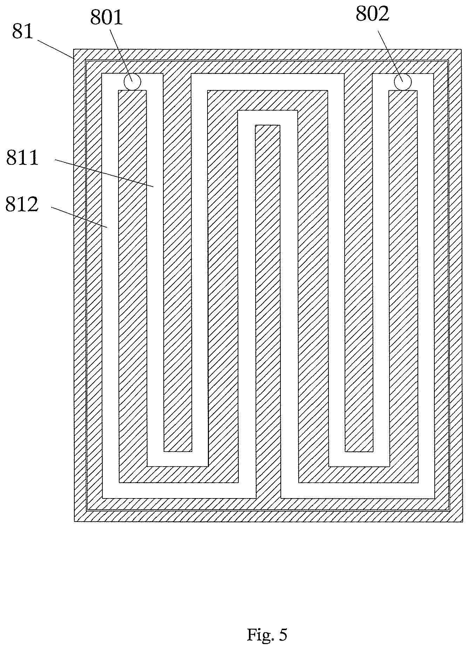

As shown in FIG. 1 and FIG. 5, in an embodiment, the cathode device of the embodiment of the present disclosure may further include a cathode conductive component 8 which may be disposed between the target material component 1 and the magnetic circuit component 2, and the target material component 1 is adhered to the cathode conductive component 8.

The cathode conductive component 8 has a cooling water passage, and the cooling water passage may have a water inlet 801 and a water outlet 802, so that cooling water may be supplied into the cooling water passage to cool the target material, so that it is advantageous to improve the sputtering effect. Meanwhile, the cooling water passage may include at least two independent branches, for example, the number of which is two, three, etc. Each branch is communicated between the water inlet 801 and the water outlet 802 and does not intersect each other, thereby expanding the heat dissipation area and improving heat radiation. In addition, the cooling water passage may extend in a curved shape, for example, in a smooth wave line shape, but which will not be limited thereto, and may also extend in a folded line shape, such as a zigzag shape, a square wave shape and the like, which is advantageous for increasing the length of the cooling water passage and improving the heat dissipation. Of course, the cooling water passage may also extend in a straight line.

For example, the cathode conductive component 8 may include a cathode conductive plate 81 and a cooling partition 82, wherein:

As shown in FIG. 5, the shape of the edge profile of the cathode conductive plate 81 may be the same as that of the target material component 1, and the material of the cathode conductive plate 81 is processed from high-purity copper, and the surface is passivated to prevent oxidation. Of course, other conductive materials are also possible. The magnetron sputtering power source is connected to the back plate 102 and the target material 101 of the target material component 1 by the cathode conductive plate 81 through the electrical connection copper to form an electric field. Meanwhile, the surface of the cathode conductive plate 81 adjacent to the target material component1 is provided with two cooling grooves for forming the cooling water passage, which include a first cooling groove 811 and a second cooling groove 812. Both the first cooling groove 811 and the second cooling groove 812 may extend in a square wave shape and may not intersect each other. Meanwhile, both the water inlet 801 and the water outlet 802 may be disposed on the cathode conductive plate 81, and the first cooling tank 811 and the second cooling tank 812 are both communicated between the water inlet 801 and the water outlet 802 to form two branches for flowing cooling water, thereby ensuring better heat dissipation of the target material component 1.

The first cooling groove 811 and the second cooling groove 812 are mechanically formed on the cathode conductive plate 81. The structure of the cooling water passage is advantageous for increasing a flowing area of the cooling water on the cathode conductive plate 81, so that the cooling water of the entire back of the target material component 1 uniformly flows. Compared to a cathode cooling system of a single cooling water passage, consumption of the cooling water is not increased, thereby improving the cooling effect and simultaneously reducing consumption of the cooling water.

The shape of the cooling partition 82 may be the same as that of the cathode conductive plate 81, and the material may be brass or other materials. At the same time, the cooling partition 82 may be disposed on the surface of the cathode conductive plate 81 adjacent to the target material component 1, and may shield the first cooling groove 811 and the second cooling groove 812. Moreover, the cooling partition 82 may be sealingly fitted to the cathode conductive plate 81 through the cooling seal washer 14, and may be press-fitted to the cathode conductive plate 81 through the partition pressure block 11 located above, thereby making the cathode conductive member 8 more stable. The first cooling groove 811 and the second cooling groove 812 are covered by the cooling partition 82 to enclose a cooling water passage having two branches. Further, the back plate 102 of the target material component 1 may be press-fitted to the cooling partition 82 by the target material pressure block 12 located above, thereby making the target material component 1 more stable.

In other embodiments of the present disclosure, the cathode conductive plate 81 and the cooling partition 82 may be of a unitary structure as long as they are electrically conductive and can form the above-described cooling water passage.

As shown in FIG. 1, in one embodiment, the embodiment of the present disclosure may further include a protective cover 9 having a receiving cavity 91 and an open end communicating with the receiving cavity 91. The cathode conductive component 8 may cover the open end, and the target material component 1 may be disposed on the surface of the cathode conductive component 8 away from the protective cover 9. The magnetic circuit component 2, the transmission component 3, the driving component 4 and the guide component 5 may be disposed within the receiving cavity 91, and the magnetic circuit component 2 may slide within the receiving cavity 91.

For example, a bracket 92 may be provided with the receiving cavity 91, the drive screw 31 of the transmission component 3 may be rotatably disposed to penetrate through the bracket 92. At the same time, the guide rail 51 of the guide component 5 may also be disposed to penetrate through the bracket 92, thereby supporting the drive screw 31 and the guide rail 51 by the bracket 92. Of course, the drive screw 31 and the guide rail 51 may also be disposed within the receiving cavity 91 in other ways. The magnetic circuit component 2 may be connected with the transmission component 3 and the guide component 5. For the connection manner, reference may be made to the above embodiments, which will not be described in detail herein.

The insulating block 10 may be fixed on both sides of the open end, and the insulating block 10 may be an insulating material such as polytetrafluoroethylene (PTFE). Both sides of the cathode conductive plate 81 of the cathode conductive member 8 may be mounted on the insulating block 10 and may be sealingly fitted to the insulating block 10 through the sealing ring 15. Of course, the cathode conductive plates 81 may also be directly mounted on both sides of the open end. The back plate 102 of the target material component 1 may be disposed on the cooling partition 82 of the cathode conductive component 8, and may be press-bonded and fixed by the target material pressure block 12. A vacuum pressure block 13 is press-bonded to the insulating block 10, and the vacuum pressure block 13 is located outside the target material pressure block 12. The vacuum pressure block 13 may be sealingly fitted to the insulating block 10 through the vacuum seal washer 16. In addition, an anode cover 17 may be disposed on the target material pressure block 12.

It should be noted that the cathode device of the magnetron sputtering apparatus of the embodiment of the present disclosure may further include other components, which specifically refer to the existing cathode device and will not be described in detail herein.

An embodiment of the present disclosure also provides a magnetron sputtering apparatus, which may include the cathode device of any of the above embodiments. Moreover, a base material may be further included, and the base material may be disposed on a side of the target material component 1 away from the magnetic circuit component 2, and of course, other components may also be included, which will not be described in detail herein. The cathode device used in the magnetron sputtering apparatus of the embodiment of the present disclosure is the same as the cathode device in the embodiment of the cathode device described above, and therefore has the same advantageous effects, which will not be described herein.

Other embodiments of the present disclosure will be apparent to those skilled in the art when considering the specification and implementing the present disclosure. The present application is intended to cover any variations, uses, or adaptations of the present disclosure, which are in accordance with the general principles of the present disclosure and include common general knowledge or conventional technical means in the art that are not disclosed in the present disclosure. The specification and examples are to be regarded as illustrative only, and the true scope and spirit of the present disclosure is defined by the appended claims.

## Claims

1. A cathode device of a magnetron sputtering apparatus, comprising:
a target material component (1);
a magnetic circuit component (2) configured to be arranged opposite to the target material component (1), wherein the magnetic circuit component (2) comprises a plurality of magnetic circuit units (21), and each of the magnetic circuit units (21) can independently generate magnetic field;
a transmission component (3), connected with each of the magnetic circuit units (21);
a driving component (4) configured to drive the magnetic circuit component (2) to reciprocate between a first position and a second position in a preset direction by the transmission component (3).

2. The cathode device according to claim 1, wherein the transmission component (3) comprises:
a drive screw (31) disposed in the preset direction;
a plurality of driving sliders (32) connected with the magnetic circuit units (21) in one-to-one correspondence, wherein each of the driving sliders (32) is sleeved on the drive screw (31) and is threaded connected with the drive screw (31).

3. The cathode device according to claim 1, wherein the cathode device further comprises at least one guide component (5) comprising:
a guide rail (51) disposed in the preset direction;
a plurality of guide sliders (52) connected with the magnetic circuit units (21) in one-to-one correspondence, wherein each of the guide sliders (52) is slidably connected with the guide rail (51).

4. The cathode device according to claim 1, wherein the cathode device further comprises:
a first limit component (6) configured to be triggered when the magnetic circuit component (2) moved to the first position, wherein the first limit component (6) controlls the magnetic circuit component (2) to move towards the second position by the driving component (4);
a second limit component (7) configured to be triggered when the magnetic circuit component (2) moved to the second position, wherein the second limit component (7) controlls the magnetic circuit component (2) to move towards the first position by the driving component (4).

5. The cathode device according to claim 4, wherein both the first limit component (6) and the second limit component (7) are proximity switches.

6. The cathode device according to claim 1, wherein each of the magnetic circuit units (21) comprises:
an insulating mat (211) connected with the transmission component (3);
a yoke (212) disposed at a surface of the insulating mat (211) adjacent to the target material component (1);
a magnet (213) disposed at a surface of the yoke (212) adjacent to the target material component (1).

7. The cathode device according to any one of claims 1-6, wherein the cathode device further comprises:
a cathode conductive component (8) disposed between the target material component (1) and the magnetic circuit component (2),
wherein the target material component (1) is adhered to the cathode conductive component (8),
wherein the cathode conductive component (8) has a cooling water passage, and the cooling water passage has a water inlet (801) and a water outlet (802), and
wherein the cooling water passage comprises at least two independent branches, each of independent brances is connected between the water inlet (801) and the water outlet (802).

8. The cathode device according to claim 7, wherein the cooling water passage extends in a curved or polylined shape.

9. The cathode device according to claim 7, wherein the cathode conductive component (8) comprises:
a cathode conductive plate (81) disposed between the target material component (1) and the magnetic circuit component (2), wherein the cathode conductive plate (81) is provided with a cooling groove;
a cooling partition (82) configured to seal a surface of the cathode conductive plate (81) adjacent to the target material component (1) for covering the cooling groove sealingly to form the cooling water passage.

10. The cathode device according to claim 9, wherein the cathode device further comprises:
a protective cover (9) having a receiving cavity (91),
wherein the receiving cavity (91) has an open end,
wherein the cathode conductive component (8) covers the open end and is fixed to the open end,
wherein the target material component (1) is fixed to a surface of the cathode conductive component (8) away from the protective cover (9), and
wherein the magnetic circuit component (2), the transmission component (3) and the driving component (4) are all disposed within the receiving cavity (91).

11. A magnetron sputtering apparatus, wherein the apparatus comprises a cathode device according to any one of claims 1-10.
